# EUROPEAN PATENT SPECIFICATION

(11) **EP 0 620 953 B1**
(45) Date of publication and mention of the grant of the patent: **04.02.1998**
(21) Application number: 94900491.5
(22) Date of filing: 01.11.1993
(51) Int. Cl.: H02N 13/00, H01L 21/00

(54) **ELECTROSTATIC WAFER CLAMP**
ELEKTROSTATISCHE KLEMMVORRICHTUNG ZUR HALTERUNG EINER WAFER
DISPOSITIF DE SERRAGE ELECTROSTATIQUE DE TRANCHE

(30) Priority: 06.11.1992 US 972617
(43) Date of publication of application: 26.10.1994
(73) Proprietor: VARIAN ASSOCIATES, INC., Palo Alto, California 94304 (US)
(72) Inventor: FRUTIGER, A., William, Beverly, MA 01915 (US)
(74) Representative: Cline, Roger Ledlie
(86) International application number: US9310502
(87) International publication number: WO9411944

(56) References cited:
- EP-A- 0 460 955
- US-A- 3 717 801
- US-A- 4 184 188
- US-A- 4 384 918
- US-A- 4 480 284
- US-A- 4 520 421
- US-A- 4 922 099
- US-A- 5 103 367
- US-A- 5 166 856
- US-A- 5 179 498
- Review of Scientific Instruments, October 1973, G.A. WARDLY, "Electrictrostatic Wafer Chuck for Electron Beam Microfabrication", pages 1506-1509, see pages 1508-1509.

## Description

This invention relates to apparatus for processing semiconductor wafers and, more particularly, to apparatus for electrostatic clamping of semiconductor wafers in a vacuum processing chamber. The apparatus of the invention is particularly useful in ion implantation systems, but is not limited to such use.

In the fabrication of integrated circuits, a number of well-established processes involve the application of ion beams to semiconductor wafers in vacuum. These processes include, for example, ion implantation, ion beam milling and reactive ion etching. In each instance, a beam of ions is generated in a source and is directed with varying degrees of acceleration toward a target wafer. Ion implantation has become a standard technique for introducing conductivity-altering impurities into semiconductor wafers. A desired impurity material is ionized in an ion source, the ions are accelerated to form an ion beam of prescribed energy and the ion beam is directed at the surface of the wafer. The energetic ions in the beam penetrate into the bulk of the semiconductor material and are embedded in the crystalline lattice of the semiconductor material to form a region of desired conductivity.

The target mounting site is a critical part of an ion implantation system. The target mounting site is required to firmly clamp a semiconductor wafer in a fixed position for ion implantation and, in most cases, to provide cooling of the wafer. In addition, means must be provided for exchanging wafers after completion of ion implantation. Cooling of wafers is particularly important in commercial semiconductor processing wherein a major objective is to achieve a high throughput in terms of wafers processed per unit time. One way to achieve high throughput is to use a high current ion beam so that the implantation process is completed in a shorter time. However, large amounts of heat are likely to be generated by the high current ion beam. The heat can result in uncontrolled diffusion of impurities beyond prescribed limits in the wafer and in degradation of patterned pnotoresist layers.

It is usually necessary to provide wafer cooling in order to limit the maximum wafer temperature to about 100°C.

A number of techniques for clamping a semiconductor wafer at the target mounting site are known in the art. According to one well-known technique, the wafer is clamped against a platen by a peripheral clamping ring which engages the outer periphery of the front surface of the wafer. The front surface of the wafer is exposed for ion implantation. However, the outer periphery of the wafer cannot be utilized for integrated circuit devices since the clamping ring blocks ion implantation of that portion of the wafer. Another disadvantage is that peripheral clamping does not result in physical contact between the wafer and a conventional flat metal platen over the entire wafer surface area. Since the wafer does not physically contact a large percentage of the platen surface that is intended for thermal transfer, the rate of thermal transfer from the semiconductor wafer is significantly reduced in a vacuum environment. Heat transfer by radiation from the wafer is inadequate, except for low current ion beams. In the case of high current ion beams, physical contact between the wafer and the platen over the area of the wafer is required to ensure sufficient cooling by conductive thermal transfer.

A variety of techniques have been disclosed for ensuring a high rate of thermal transfer with peripheral clamping. A contoured heat sink surface for optimizing conductive heat transfer between a wafer and a heat sink is disclosed in U.S. Patent No. 4,535,835, issued August 20, 1985 to Holden. The heat sink surface is contoured so as to impose a load that results in a uniform contact pressure distribution and a stress approaching the elastic limit of the wafer for a peripherally-clamped wafer.

Another prior art technique for thermal transfer in vacuum involves the use of a thermally-conductive polymer between a semiconductor wafer and a heat sink. A tacky, inert polymer film for providing thermal contact between a wafer and a heat sink is disclosed in U.S. Patent No. 4,139,051, issued February 13, 1979 to Jones et al. The polymer film disclosed by Jones et al has a sticky surface.which is used to advantage to retain the wafer in position during processing. Such a sticky surface is unacceptable in automated processing wherein the wafer must easily be removed after ion beam treatment. The sticky surface can result in wafer breakage and can easily become contaminated.

An automated wafer clamping mechanism utilizing a pliable, thermally-conductive layer between a semiconductor wafer and a heat sink is disclosed in U.S. Patent No. 4,282,924 issued August 11, 1981 to Faretra. The wafer is clamped at its periphery to a convexly-curved platen having a layer of thermally-conductive silicone rubber on its surface.

The technique of gas conduction has also been utilized for wafer cooling in vacuum. Gas is introduced into a cavity or microscopic voids behind a semiconductor wafer and effects thermal coupling between the wafer and a heat sink. Gas-assisted, solid-to-solid thermal transfer with a semiconductor wafer is disclosed in U.S. Patent No. 4,457,359, issued July 3, 1984 to Holden.

All of the known prior art peripheral clamping techniques result in wasted wafer area. In many of these configurations, thermal transfer is inadequate due to poor contact between the semiconductor wafer and the platen surface. Furthermore, the curved platens disclosed in the aforementioned Patent Nos. 4,535,835 and 4,282,924 introduce a variation in the angle of incidence of the ion beam on the wafer surface for different locations on the wafer surface. In ion implantation, variations in incidence angle can be a serious problem. The depth of penetration of incident ions is a function of incidence angle because of the well-known channeling effect. Therefore, it is desirable in ion implantation to provide a constant angle of incidence of the ion beam on the wafer surface over the surface area of the semiconductor wafer.

A wafer clamping technique which eliminates the requirement for a peripheral clamping ring and which permits use of a flat platen surface is centrifugal clamping. In centrifugal clamping, the wafer site is rotated about an axis of rotation. The platen surface is oriented at an angle with respect to the axis of rotation so that centrifugal force presses the wafer against the platen surface. A thermal transfer technique which utilizes centrifugal clamping and a flat platen surface having a pliable, thermally-conductive polymer layer for effecting thermal transfer is disclosed in U.S. Patent No. 4,832,781, issued May 23, 1989 to Mears. The disclosed technique provides highly satisfactory cooling performance. However, the requirement for rotating the wafer site in order to provide centrifugal clamping adds complexity and is not always practical.

Another known technique for clamping semiconductor wafers involves the use of electrostatic forces. A dielectric layer is positioned between a semiconductor wafer and a conductive support plate. A voltage is applied between the semiconductor wafer and the support plate, and the wafer is clamped against the dielectric layer by electrostatic forces. An electrostatic wafer clamp is disclosed by G.A. Wardly in "Electrostatic Wafer Chuck for Electron Beam Microfabrication", Rev. Sci. Instrum., Vol. 44, No. 10, Oct. 1972, pp. 1506-1509 and in U.S. Patent No. 3,993,509 issued November 23, 1976 to McGinty. Electrostatic wafer clamp arrangements which utilize a thermally-conductive material to remove heat from the wafer are disclosed in U.S. Patent No. 4,502,094, issued February 26, 1985 to Lewin et al, U.S. Patent No. 4,665,463, issued May 12, 1987 to Ward et al and U.S. Patent No. 4,184,188, issued January 15, 1980 to Briglia. The Briglia patent discloses a support plate having layers of thermally-conductive, electrically-insulative RTV silicone. Electrostatic wafer clamps are also disclosed in U.S. Patent No. 4,480,284, issued October 30, 1984 to Tojo et al, U.S. Patent No. 4,554,611, issued November 19, 1985 to Lewin, U.S. Patent No. 4,724,510, issued February 9, 1988 to Wicker et al and U.S. Patent No. 4,412,133, issued October 25, 1983 to Eckes et al.

U.S. Patent No. 4,520,421, issued May 28, 1985 to Sakitani et al, discloses a specimen supporting device including a pair of specimen attracting portions each having an electrode on the lower surface of an insulating member. When a voltage is applied between the pair of specimen attracting portions, the specimen is electrostatically attracted to the upper surface. The voltage can be AC or DC. An embodiment having eight arcuate specimen attracting portions with voltages of alternately opposite polarities is disclosed.

U.S. Patent No. 5,103,367, issued April 7, 1972 to Horowitz et al, discloses an electrostatic chuck for semiconductor wafers having at least three electrodes. Two of the electrodes embedded in a dielectric film are energized by an AC supply to provide sine wave fields of controlled amplitude and phase. The relative phases and amplitudes of the electrode voltages are adjusted to null the voltage induced on the surface of the wafer. In one embodiment, the substrate support surface comprises a thin ceramic layer such as sapphire (Al₂O₃).

Problems associated with prior art electrostatic wafer clamping arrangements include inadequate clamping force, damage to devices on the wafer by charging currents, difficulty in making electrical contact to the semiconductor wafer, and wafer sticking to the platen after the clamping voltage has been removed. In addition, thermal transfer characteristics have usually been inadequate for high current ion implantation applications, since a significant portion of the platen surface area is devoted to making electrical contact with the semiconductor wafer. See, for example, the aforementioned Patent No. 4,502,094.

EP-A-0460955 discloses a three-phase wafer clamping apparatus including a platen divided into three electrically-isolated sections. The three phases of the clamping voltage are connected to respective platen sections.

The present invention improves on that arrangement according to the construction set out in claim 1.

An example of the invention will now be described with reference to the accompanying drawings in which:
FIG. 1 is a schematic plan view of an electrostatic wafer clamping apparatus which has a platen with six electrodes and which utilizes a six phase clamping voltage;
FIG. 2 is a cross-sectional view, taken along the line 13-13 of FIG. 1, of the wafer clamping apparatus of FIG. 1;
FIG. 3 is a schematic block diagram of an example of a clamping control circuit for generating voltages for operation of the wafer clamping apparatus of FIG. 1;
FIG. 4 is a timing diagram that illustrates the six voltage waveforms generated by the clamping control circuit of FIG. 3;
FIG. 5 is a cross-sectional view of an electrostatic wafer clamping apparatus which has a platen with six electrodes and a peripheral grounding ring for grounding of the workpiece;
FIGS. 6 to 8 illustrate charging currents for a three phase sine wave clamping voltage, a three phase square wave clamping voltage and a six phase square wave clamping voltage, respectively; and
FIG. 9 is a cross-sectional view of an electrostatic wafer clamping apparatus similar to the clamping apparatus shown in FIGS. 1 and 2 and including wafer cooling.

An electrostatic wafer clamping apparatus includes a platen 200 and a clamping control circuit 202 for applying clamping voltages to the platen 200 when clamping of a workpiece is desired. The platen 200 includes a support plate, or platen base 204, and an insulating substrate 206 mounted on an upper surface of platen base 204. The platen base 204 and the insulating substrate 206 are generally circular and may have a central opening 208 for a wafer lift mechanism (not shown).

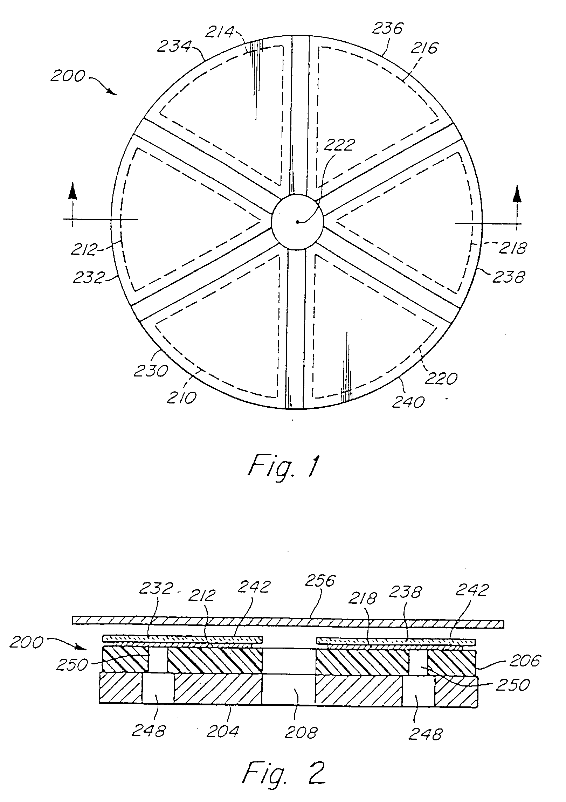

Six equally-spaced electrodes 210, 212, 214, 216, 218 and 220 are located between an upper surface of insulating substrate 206 and sector dielectric insulators 230, 232, 234, 236, 238 and 240, respectively. The electrodes are preferably thin metal layers formed on the lower surfaces of the respective sector dielectric insulators. The electrodes 210, 212, 214, 216, 218 and 220 preferably have equal areas and are symmetrically disposed with respect to a center 222 of the platen 200. The electrodes are electrically isolated from each other and, in a preferred embodiment, are sector shaped as shown in FIG. 1. The upper surfaces of dielectric insulators 230, 232, 234, 236, 238 and 240 are coplanar and define a wafer clamping surface 242. Preferably, the dielectric insulators overlap the edges of the respective electrodes to prevent contact between the electrodes and the wafer.

The platen base 204 and the insulating substrate 206 are provided with aligned openings 248 and 250, respectively, underlying each of the electrodes. The openings 248 and 250 permit electrical connection to each of the electrodes. A semiconductor wafer 256 is shown in FIG. 2 positioned above clamping surface 242. When clamping voltages are applied to electrodes 210, 212, 214, 216, 218 and 220 as described in detail below, the wafer 256 is electrostatically clamped in a fixed position against clamping surface 242.

The dielectric insulators 230, 232, 234, 236, 238 and 240 are preferably a hard ceramic material that has high dielectric strength and high permittivity and does not exhibit bulk polarization at the frequency and voltage used for clamping. Preferred materials include alumina, sapphire and aluminum nitride. In a preferred embodiment, the dielectric insulators are fabricated of alumina having a thickness of about 0.2 mm. This thickness permits reliable clamping with a voltage having a peak amplitude of about 1000 volts. The upper surfaces of the dielectric insulators, which define the clamping surface 242, are ground flat to within 0.025 mm (0.001 inch). The flat clamping surface can be obtained using conventional grinding, polishing and lapping techniques. The alumina dielectric insulators provide a hard wafer clamping surface that has long term durability, is extremely clean and does not cause wafer sticking.

The electrodes 210, 212, 214, 216, 218 and 220 are preferably formed by evaporation of metal layers on the lower surfaces of the respective dielectric insulators. In particular, the electrodes preferably comprise a very thin titanium layer applied directly to the alumina dielectric insulator as a wetting agent and a molybdenum layer over the titanium for high conductivity. The molybdenum is selected because it has a thermal expansion coefficient that is closely matched to the thermal expansion coefficient of alumina. The total thickness of each electrode is typically on the order of about one micrometer. It is important that the electrode be formed on the lower surface of the dielectric insulator so as to avoid any air gap between the electrode and the insulator. Even a slight air gap between the electrode and the insulator or between the wafer and the insulator can cause a significant reduction in clamping force. A thicker dielectric insulator requires a larger clamping voltage, which could potentially damage devices on the wafer. A thinner dielectric insulator may lack structural stability and durability.

In the preferred embodiment, a separate dielectric insulator is fabricated for each electrode, with the electrode having a smaller area than the dielectric insulator. In another embodiment, the dielectric insulator can be formed as a circular disk having a central opening, if necessary, with multiple electrodes formed on its lower surface by evaporation. This configuration may be practical for relatively small platens having diameters of 100 mm or less. For larger diameter platens, separate dielectric insulators are more easily fabricated.

The insulating substrate 206 has sufficient thickness to support the platen structure and to electrically isolate the electrodes. The insulating substrate is preferably fabricated of the same material as the dielectric insulators for matching of thermal expansion coefficients. In the preferred embodiment, the substrate 206 is fabricated of alumina. The platen base 204 is typically fabricated of a metal such as aluminum.

The dielectric insulators having electrodes formed on their lower surfaces are bonded to the upper surface of the insulating substrate 206. Preferably, a thermoplastic tetrafluoroethylene fastener, such as Teflon FEP film available from DuPont- Company, is used as an adhesive. The thermoplastic fastener is placed between the dielectric insulators and the insulating substrate 206, and the assembly is heated to approximately 300°C in vacuum. The tetrafluoroethylene fastener melts and forms a secure bond between the dielectric insulators and the insulating substrate 206. The tetrafluoroethylene bonding technique is very clean and does not cause outgassing during vacuum processing.

The clamping voltages applied to the electrodes of platen 200 are preferably bipolar square waves having six different phases (0°, 60°, 120°, 180°, 240° and 300°). The phases of the voltages applied to electrodes on opposite sides of the platen 200 are one-half cycle, or 180°, out of phase. Thus, the voltages applied to electrodes 212 and 218 are one-half cycle out of phase; the voltages applied to electrodes 210 and 216 are one-half cycle out of phase; and the voltages applied to electrodes 214 and 220 are one-half cycle out of phase. As described below, the disclosed clamping apparatus provides reliable clamping and unclamping of wafers without requiring contact to the wafer and without producing charging currents which could potentially damage the wafer.

The six phase square wave voltages preferably have an amplitude in a range of about 900 to 1200 volts peak, with a preferred voltage of about 1000 volts peak. This voltage range provides sufficient clamping force to overcome any curvature of the wafer and cause it to conform to the clamping surface 242. Voltages higher than this range may cause damage to devices on the wafer. The frequency of the square wave voltages is in a range of about 1 Hz to 300 Hz and is preferably in a range of about 20 to 50 Hz, with a most preferred operating frequency of about 30 Hz. Lower frequencies produce surface charging, which can cause wafer sticking. Higher frequencies provide reduced holding force for a given charging current. For a clamping voltage having a frequency of 30 Hz, the switching time of the square wave is preferably limited to about 3 milliseconds. This relatively low switching speed limits the rate at which the electrodes charge and thereby limits voltage transients which could potentially damage the wafer.

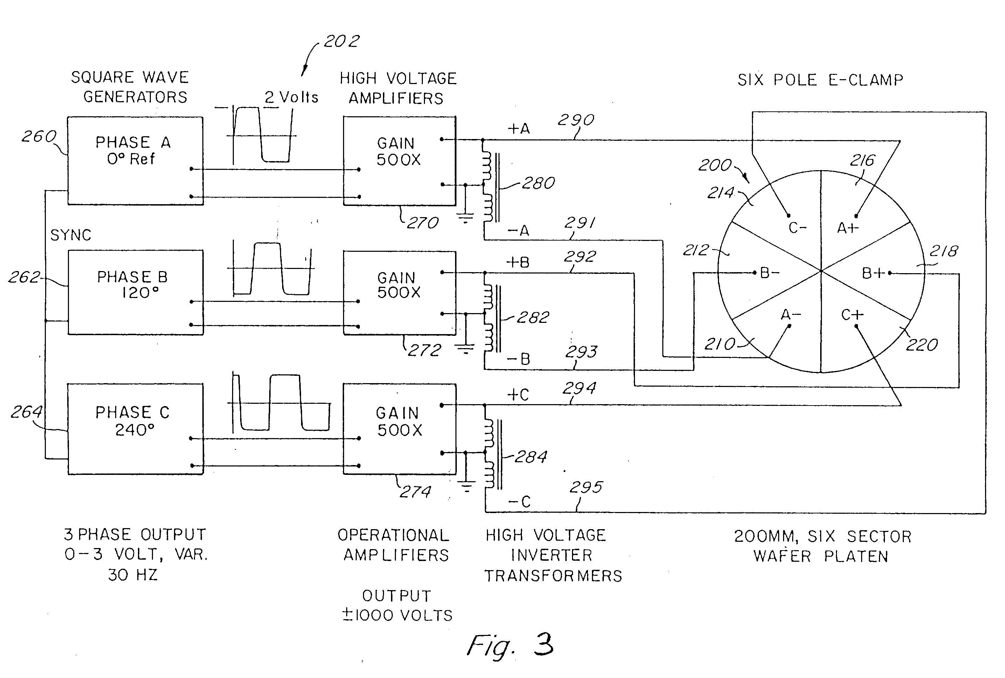

A schematic block diagram of clamping control circuit 202 for applying clamping voltages to platen 200 is shown in FIG. 3. It will be understood that the clamping control circuit 202 is only one example of a suitable circuit for generating the clamping control voltages. Any circuit capable of generating square wave voltages of the required amplitude, frequency and phases can be utilized.

The clamping control circuit 202 includes square wave generators 260, 262 and 264 which generate low voltage square waves of equal amplitude and frequency. The frequency is preferably about 30 Hz. The phases of the output square waves differ by 120°. Thus, square wave generator 260 produces a square wave at a reference phase of 0°; square wave generator 262 produces a square wave at a phase of 120°; and square wave generator 264 produces a square wave at a phase of 240°. The outputs of square wave generators 260, 262 and 264 are input to high voltage amplifiers 270, 272 and 274, respectively. The amplifiers 270, 272 and 274 increase the amplitude of the respective square waves to approximately 1000 volts peak.

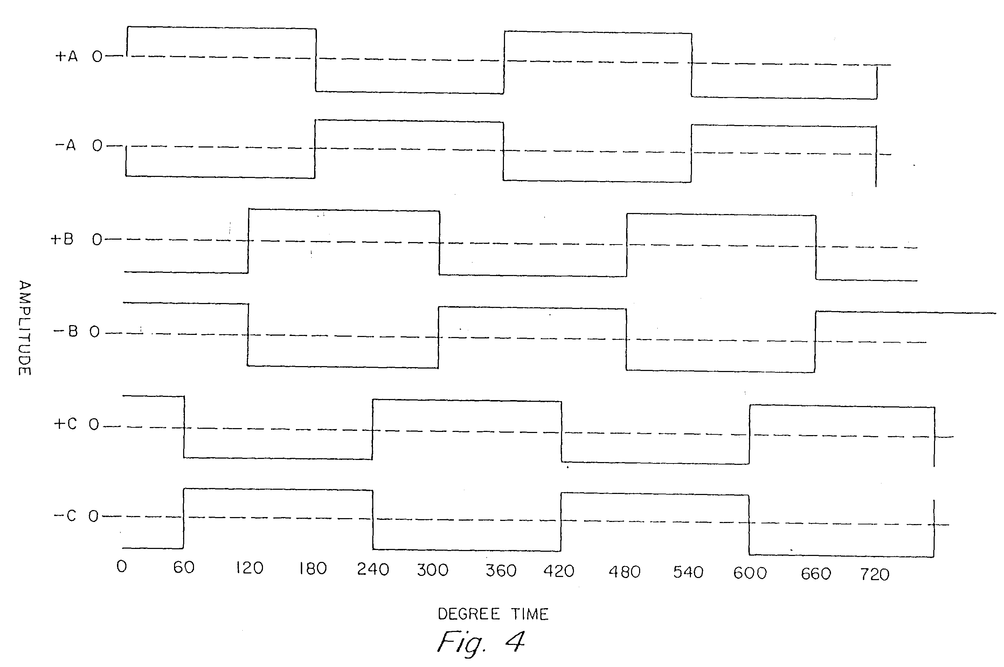

The outputs of amplifiers 270, 272 and 274 are applied to high voltage inverter transformers 280, 282 and 284, respectively. The transformers 280, 282 and 284 have grounded center taps and produce two output voltages that are 180°, or one-half cycle, out of phase. Thus, the outputs of transformer 280 on line 290 (+A) and line 291 (-A) are bipolar square waves that are one-half cycle out of phase. Similarly, the outputs of transformer 282 on line 292 (+B) and line 293 (-B) are bipolar square waves that are one-half cycle out of phase and are shifted by 120° relative to the outputs of transformer 280. The outputs of transformer 284 on line 294 (+C) and line 295 (-C) are one-half cycle out of phase and are shifted by 240° relative to the outputs of transformer 280. The voltage waveforms +A, -A, +B, -B, +C and -C are shown in FIG. 4. The outputs of transformer 280 on lines 290 and 291 are coupled to electrodes 216 and 210, respectively. The outputs of transformer 282 on lines 292 and 293 are coupled to electrodes 218 and 212, respectively. The outputs of transformer 284 on lines 294 and 295 are coupled to electrodes 220 and 214, respectively. In a variation of the wafer clamping apparatus, the connections to electrodes 218 and 212 are reversed. In this configuration, line 292 is connected to electrode 212, and line 293 is connected to electrode 218.

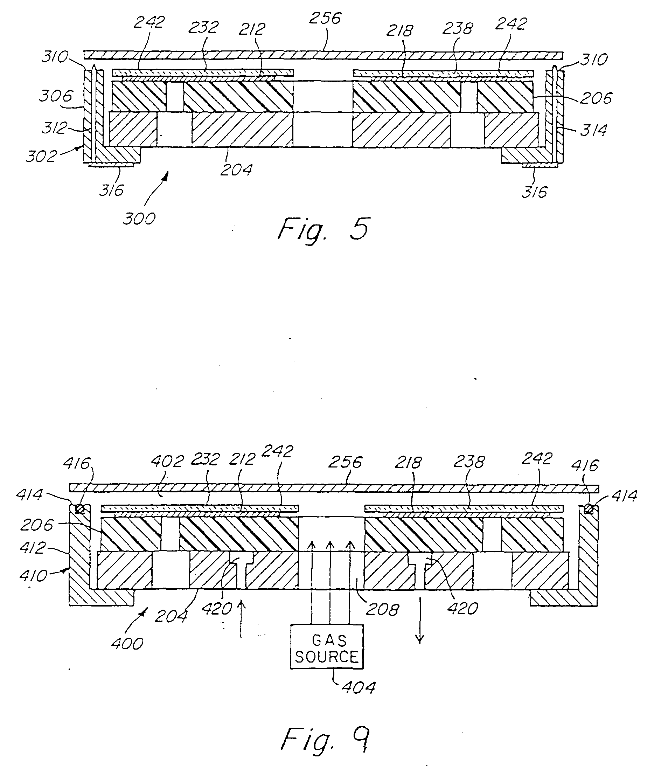

In some cases, it may be desirable to ground the wafer in order to eliminate charge buildup caused by the ion beam, to compensate for any imbalance in the wafer clamping apparatus and to compensate for wafer imperfections. A wafer clamping apparatus incorporating wafer grounding is shown in FIG. 5. Like elements in FIGS. 2 and 5 have the same reference numerals. A platen 300 includes platen base 204, insulating substrate 206, electrodes 210 to 220 and sector dielectric insulators 230 to 240 as described above. A conductive grounding ring 302 surrounds the periphery of platen base 204 and insulating substrate 206. The grounding ring 302 is attached to platen base 204 and includes an annular wall 306 having a top surface 310 that is coplanar with clamping surface 242. When the wafer 256 is clamped to surface 242, the outer periphery of the wafer contacts clamping ring 302, thereby grounding the wafer 256. To insure reliable contact with wafer 256, spring loaded grounding pins 312, 314, etc. are preferably provided. The pins 312 and 314 are normally biased slightly above surface 310 by springs 316. When the wafer 256 is clamped against surface 242 by electrostatic forces, the pins 312, 314, etc. are depressed downwardly, and the springs urge the pins into contact with the wafer, thereby ensuring reliable contact with wafer 256. Preferably, three or more grounding pins are utilized in grounding ring 302.

The clamping apparatus shown in FIGS. 1 - 5 in effect operates as a six phase clamp. By providing opposite phases to electrodes on opposite sides of the platen 200, electrical contact with the wafer is not required for clamping. By utilizing bipolar square wave clamping voltages as described, a clamping voltage is applied to the wafer at all times and vibration is eliminated. Even when two of the clamping voltages are passing through zero volts, four other clamping voltages are at full amplitude.

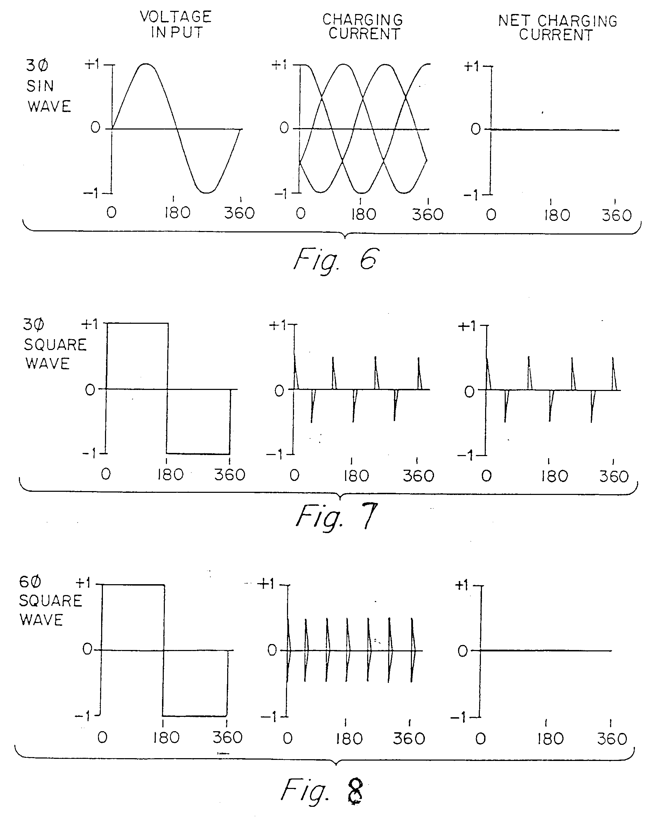

A further advantage of the third embodiment of the invention is illustrated to reference to FIGS. 6 to 8. In an electrostatic wafer clamp employing three sectors and a three phase sine wave clamping voltage, there is perfect cancellation of the AC capacitive charging currents flowing from each sector to the wafer. The total charging current is given by the sum of three sinusoidal currents, each 120° out of phase, and this sum is identically equal to zero as illustrated in FIG. 6. This cancellation means that not only is electrical contact to the wafer not required in order to provide the holding force, but that the electrical potential of the wafer will remain zero at all times while it is held on the platen, even though there is no electrical contact to the wafer.

However, the use of a sinusoidal clamping voltage is not optimal in a wafer clamping apparatus. Square wave voltages are preferred for two reasons. First, for a given peak voltage, the mean holding force is larger for a square wave clamping voltage than for a sine wave clamping voltage. Second, with square wave clamping voltages, there is a reduction in the period of time for which the holding force on any given sector is zero or close to zero. Consequently, vibration of the wafer is greatly reduced compared to the use of sine waves.

Unfortunately, when square wave voltages are used in a three phase clamping apparatus as shown in EP-A-460955, then the advantage of charging current cancellation is lost. Charge passes to the wafer in a series of current spikes and, unless the wafer is grounded by an effective electrical contact, the electrical potential of the wafer will change at a frequency that is three times the three phase square wave frequency, as illustrated in FIG. 7. Such voltage excursions of the wafer surface, which may amount to many hundreds of volts in a practical device, can cause damage to sensitive devices being processed on the wafer, or may interfere with the process being carried out, such ion implantation or plasma etching.

The charging currents for the six sector wafer clamping apparatus of FIGS. 1 and 2 are shown in FIG. 8. In this case, the current spike from each sector is cancelled by a simultaneous spike of opposite polarity from the opposing sector on the platen. The net charging current therefore cancels to zero. Furthermore, for the six sector wafer clamping apparatus, the charging current cancels for any arbitrary input waveform.

As noted above, the dielectric insulators 230, 232, 234, 236, 238 and 240 in the wafer clamping apparatus of FIGS. 1 and 2 are preferably a hard ceramic material. Furthermore, the dielectric insulators and the wafer have nominally flat surfaces. This results in physical contact between the wafer and the dielectric insulators over a relatively small percentage of their surface areas. As a result, thermal transfer from the wafer 256 to the dielectric insulators is relatively poor when the clamping apparatus is operated in vacuum. Thermal transfer by conduction occurs only over those areas of the wafer 256 that are in physical contact with the dielectric insulators.

Since wafer cooling is frequently a requirement in ion implantation systems, a variation of the third embodiment of the invention including wafer cooling is shown in FIG. 9. Like elements in FIGS. 13 and 17 have the same reference numerals. A platen 400 includes platen base 204, insulating substrate 206, six electrodes 210-220 and six sector dielectric insulators 230-240, as described above in connection with FIG. 2.

In addition, the platen shown in FIG.9 includes means for introducing a gas into a region 402 between wafer 256 and clamping surface 242. Although the wafer 256 is shown in FIG. 9 raised above clamping surface 242, it will be understood that even when the wafer 256 is firmly clamped to clamping surface 242, voids will exist between the wafer and the clamping surface due to wafer irregularities and warping, and microscopic variations in the surfaces. A gas is coupled from a gas source 404, shown schematically in FIG. 9, through a suitable conduit (not shown) and through central opening 208 to the region 402 between wafer 256 and clamping surface 242.

The platen 400 further includes an annular sealing ring 410 surrounding the periphery of platen base 204 and insulating substrate 206. The annular sealing ring 410 includes an annular wall 412 having a top surface 414 that is coplanar with clamping surface 242. An elastomer sealing ring 416 is mounted in a groove in top surface 414. When the wafer 256 is clamped to surface 242, the elastomer ring 416 is partially compressed and seals the region 402 at its outer periphery. The peripheral seal prevents the gas introduced from source 404 from escaping into the vacuum chamber.

The gas is typically nitrogen or other thermally-conductive gas at a pressure of about 133 to 5333 Pa (1-40 torr). The pressure of the gas is selected to maximize thermal conduction without lifting the wafer 256 from clamping surface 242. The gas in region 402 between wafer 256 and clamping surface 242 promotes conduction of thermal energy between wafer 256 and clamping surface 242 and iimits heating of the wafer. Techniques for gas conduction cooling are well known to those skilled in the art.

According to a further feature of the invention, the platen 400 includes cooling means ror removing thermal energy transferred from the wafer to the platen. In the embodiment of FIG. 9, the platen base 204 is provided with an annular passage 420 for circulation of a cooling liquid such as water. The passage 420 includes an inlet and an outlet for connection to a liquid cooling and circulation system (not shown). It will be understood by those skilled in the art that a variety of configurations can be provided for circulation of the cooling liquid. The liquid cooling system is sealed from the remainder of the platen assembly.

When an ion beam is incident on wafer 256, heat is generated in the wafer. The heat is transferred from wafer 256 through dielectric insulators 230-240 and insulating substrate 206 to platen base 204. The thermal energy is removed from platen base 204 by the liquid cooling system. The transfer of thermal energy from wafer 256 to the platen occurs by solid-to-solid thermal conduction in the areas of physical contact between wafer 256 and clamping surface 242 and by gas conduction in the areas where the wafer 256 does not physically contact clamping surface 242.

## Claims

1. Apparatus for electrostatic clamping of a workpiece, comprising:
a platen (200) having an electrically insulating clamping surface (242) for receiving a workpiece and 2n conductive electrodes (210-220), where n is an integer equal to or greater than three, underlying and electrically isolated from said clamping surface; and
clamping control means (202) for applying AC voltages to said electrodes when clamping of the workpiece is desired, the workpiece being electrostatically clamped in a fixed position on said clamping surface when said AC voltages are applied to said electrodes, said clamping control means comprising means (260-264) for generating 2n bipolar square wave voltages having equally shifted relative phases, said square wave voltages defining n sets of square wave voltages, each of said sets including positive and negative, bipolar square wave voltages that are one half cycle out of phase, each of said bipolar square wave voltages having a predetermined switching speed selected to limit transients which could potentially damage a workpiece, and means (280-295) for coupling said sets of square wave voltages to said electrodes so as to provide symmetrical clamping of the workpiece to said clamping surface.

2. Apparatus as claimed in claim 1 wherein n=3.

3. Apparatus as claimed in claim 1 or claim 2 wherein each of said square wave voltages has a fundamental frequency in a range of 1 Hz to 300 Hz.

4. Apparatus as claimed in claim 3 wherein each of said square wave voltages has a fundamental frequency in a range of 20 Hz to 50 Hz.

5. Apparatus as claimed in claim 4 wherein each of said square wave voltages has a fundamental frequency of 30 Hz.

6. Apparatus as claimed in any one of claims 1 to 5 wherein said switching speed is 3 milliseconds.

7. Apparatus as claimed in any one of claims 1 to 6 wherein said clamping surface comprises dielectric material (230-240) selected from the group consisting of alumina, sapphire and aluminum nitride.

8. Apparatus as claimed in claim 7 wherein said dielectric material comprises alumina.

9. Apparatus as claimed in claim 8 wherein said electrodes comprise a molybdenum layer and a thin titanium layer between said molybdenum layer and said dielectric material.

10. Apparatus as claimed in any one of claims 1 to 9 wherein said clamping surface comprises thermally conductive dielectric material.

11. Apparatus as claimed in any one of claims 1 to 10 wherein said platen further includes an insulating substrate (206) for supporting each of said electrodes and said clamping surface.

12. Apparatus as claimed in claim 11 wherein said platen further includes a support plate (204) for said insulating substrate.

13. Apparatus as claimed in claim 12 wherein said support plate includes a passage (208, 420) for circulation of a cooling fluid.

14. Apparatus as claimed in any one of claims 1 to 13 wherein said electrodes are symmetrically disposed with respect to the centre of said clamping surface, the square wave voltages of each of said sets being coupled to electrodes on opposite sides of said clamping surface.

15. Apparatus as claimed in any one of claims 1 to 14 wherein said electrodes comprise metal layers underlying said dielectric material.

16. Apparatus as claimed in claim 15 wherein said electrodes comprise metal layers formed on said dielectric material.

17. Apparatus as claimed in claim 15 wherein said electrodes comprise metal layers evaporated on said dielectric material.

18. Apparatus as claimed in any one of claims 1 to 17 wherein said electrodes have equal areas.

19. Apparatus as claimed in any one of claims 1 to 18 wherein said clamping surface is flat.

20. Apparatus as claimed in any one of claims 1 to 19 wherein said platen further includes a peripheral grounding ring (302) for contacting said workpiece.

21. Apparatus as claimed in any one of claims 1 to 20 wherein said dielectric material does not exhibit bulk polarization at the frequency and voltage of said square wave voltages.

22. Apparatus as claimed in any one of claims 1 to 21 wherein said bipolar square wave voltages have a peak amplitude in a range of 900 volts to 1200 volts.

23. Apparatus as claimed in any one of claims 1 to 22 wherein said dielectric material comprises dielectric insulators, one for each of said electrodes.

24. Apparatus as claimed in claim 11, 16 and 23 wherein said dielectric insulators are bonded to said insulating substrate by tetrafluoroethylene fasteners.

25. Apparatus as claimed in any one of claims 1 to 24 further including means (404) for introducing a gas into a region between said workpiece and said clamping surface for conducting thermal energy between said workpiece and said clamping surface.

26. Apparatus as claimed in claim 25 further including means (410-416) for sealing the region between said workpiece and said clamping surface near an outer periphery thereof to prevent escape of said gas from said region.

27. Apparatus as claimed in any one of claims 1 to 26 further including means (404) for cooling said platen.

28. Apparatus as claimed in any one of the preceding claims wherein the clamping surface is circular.

29. Apparatus as claimed in claim 28 wherein said electrodes comprise sector-shaped electrodes having equal areas.

## Patentansprüche

1. Vorrichtung zur elektrostatischen Klemmung eines Werkstückes, mit:
einer Platte (200) mit einer elektrisch isolierenden Klemmoberfläche (242) zur Aufnahme eines Werkstückes und 2n leitenden Elektroden (210-220), wobei n eine ganze Zahl gleich oder größer als drei ist, welche sich unterhalb der Klemmoberfläche befinden und von dieser elektrisch isoliert sind; und
Klemmsteuermittel (202) zum Anlegen von Wechselspannungen an die Elektroden, wenn eine Klemmung des Werkstückes gewünscht ist, wobei das Werkstück elektrostatisch in einer festen Position auf der Klemmoberfläche festgeklemmt wird, wenn die Wechselspannungen an die Elektroden angelegt werden, wobei die Klemmsteuermittel Mittel (260-264) zum Erzeugen von 2n bipolaren Rechteckspannungen mit gleichmäßig verschobenen relativen Phasen enthalten, die Rechteckspannungen n Sätze von Rechteckspannungen definieren, wobei jeder der Sätze positive und negative, bipolare Rechteckspannungen enthält, welche um einen halben Zyklus aus der Phase sind, wobei jede der bipolaren Rechteckspannungen eine vorbestimmte Umschaltgeschwindigkeit aufweist, welche ausgewählt ist, um Spannungsspitzen zu begrenzen, welche möglicherweise ein Werkstück beschädigen könnten, und Mitteln (280-295) zum Ankoppeln der Sätze der Rechteckspannungen an die Elektroden, um so eine symmetrische Klemmung des Werkstückes an der Klemmoberfläche zur Verfügung zu stellen.

2. Vorrichtung nach Anspruch 1,
dadurch gekennzeichnet, daß n = 3 ist.

3. Vorrichtung nach Anspruch 1 oder 2,
dadurch gekennzeichnet, daß jede der Rechteckspannungen eine Grundfrequenz in einem Bereich von 1 Hz bis 300 Hz aufweist.

4. Vorrichtung nach Anspruch 3,
dadurch gekennzeichnet, daß jede der Rechteckspannungen eine Grundfrequenz in einem Bereich von 20 Hz bis 50 Hz aufweist.

5. Vorrichtung nach Anspruch 4,
dadurch gekennzeichnet, daß jede der Rechteckspannungen eine Grundfrequenz von 30 Hz aufweist.

6. Vorrichtung nach einem der Ansprüche 1 bis 5,
dadurch gekennzeichnet, daß die Umschaltgeschwindigkeit 3 Millisekunden beträgt.

7. Vorrichtung nach einem der Ansprüche 1 bis 6,
dadurch gekennzeichnet, daß die Klemmoberfläche dielektrisches Material (230-240) enthält, welches aus einer Gruppe ausgewählt ist, die aus Aluminiumoxid, Saphir und Aluminiumnitrid besteht.

8. Vorrichtung nach Anspruch 7,
dadurch gekennzeichnet, daß das dielektrische Material Aluminiumoxid enthält.

9. Vorrichtung nach Anspruch 8,
dadurch gekennzeichnet, daß die Elektroden eine Molybdänschicht und eine dünne Titanschicht zwischen der Molybdänschicht und dem dielektrischen Material enthalten.

10. Vorrichtung nach einem der Ansprüche 1 bis 9,
dadurch gekennzeichnet, daß die Klemmoberfläche thermisch leitfähiges, dielektrisches Material enthält.

11. Vorrichtung nach einem der Ansprüche 1 bis 10,
dadurch gekennzeichnet, daß die Platte weiterhin ein isoliertes Substrat (206) zum Abstützen jeder der Elektroden und der Klemmoberfläche einschließt.

12. Vorrichtung nach Anspruch 11,
dadurch gekennzeichnet, daß die Platte weiterhin eine Stützplatte (204) für das isolierende Substrat aufweist.

13. Vorrichtung nach Anspruch 12,
dadurch gekennzeichnet, daß die Stützplatte einen Durchgang (208, 420) für die Zirkulation eines Kühlfluides aufweist.

14. Vorrichtung nach einem der Ansprüche 1 bis 13,
dadurch gekennzeichnet, daß die Elektroden bezüglich der Mitte der Klemmoberfläche symmetrisch angeordnet sind, wobei die Rechteckspannungen jedes der Sätze an Elektroden auf gegenüberliegenden Seiten der Klemmoberfläche angekoppelt sind.

15. Vorrichtung nach einem der Ansprüche 1 bis 14,
dadurch gekennzeichnet, daß die Elektroden unter dem dielektrischen Material liegende Metallschichten aufweisen.

16. Vorrichtung nach Anspruch 15,
dadurch gekennzeichnet, daß die Elektroden auf dem dielektrischen Material gebildete Metallschichten aufweisen.

17. Vorrichtung nach Anspruch 15,
dadurch gekennzeichnet, daß die Elektroden auf dem dielektrischen Material aufgedampfte Metallschichten aufweisen.

18. Vorrichtung nach einem der Ansprüche 1 bis 17,
dadurch gekennzeichnet, daß die Elektroden die gleiche Fläche aufweisen.

19. Vorrichtung nach einem der Ansprüche 1 bis 18,
dadurch gekennzeichnet, daß die Klemmoberfläche flach ist.

20. Vorrichtung nach einem der Ansprüche 1 bis 19,
dadurch gekennzeichnet, daß die Platte weiterhin einen erdenden Umfangsring (302) zur Kontaktierung des Werkstückes aufweist.

21. Vorrichtung nach einem der Ansprüche 1 bis 20,
dadurch gekennzeichnet, daß das dielektrische Material bei der Frequenz und der Spannung der Rechteckspannungen keine Volumenpolarisation aufweist.

22. Vorrichtung nach einem der Ansprüche 1 bis 21,
dadurch gekennzeichnet, daß die bipolaren Rechteckspannungen eine Spitzenamplitude in einem Bereich von 900 Volt bis 1200 Volt aufweisen.

23. Vorrichtung nach einem der Ansprüche 1 bis 22,
dadurch gekennzeichnet, daß das dielektrische Material für jede der Elektroden einen dielektrischen Isolator aufweist.

24. Vorrichtung nach den Ansprüchen 11, 16 und 23,
dadurch gekennzeichnet, daß die dielektrischen Isolatoren an das isolierende Substrat mittels Tetrafluoroethylen-Befestigungsmitteln kontaktiert sind.

25. Vorrichtung nach einem der Ansprüche 1 bis 24,
gekennzeichnet durch Mittel (404) zum Einführen eines Gases in eine Region zwischen dem Werkstück und der Klemmoberfläche zum Überleiten von thermischer Energie zwischen dem Werkstück und der Klemmoberfläche.

26. Vorrichtung nach Anspruch 25,
gekennzeichnet durch Mittel (410-416) zum Versiegeln der Region zwischen dem Werkstück und der Klemmoberfläche in der Nähe einer äußeren Begrenzungsfläche derselben, um die Verflüchtigung von Gas aus dieser Region zu verhindern.

27. Vorrichtung nach einem der Ansprüche 1 bis 26,
gekennzeichnet durch Mittel (404) zum Kühlen der Platte.

28. Vorrichtung nach einem der vorstehenden Ansprüche,
dadurch gekennzeichnet, daß die Klemmoberfläche kreisförmig ist.

29. Vorrichtung nach Anspruch 28,
dadurch gekennzeichnet, daß die Elektroden sektorenförmige Elektroden mit gleichen Flächen aufweisen.

## Revendications

1. Appareil de serrage électrostatique comprenant:
une platine (200) ayant une surface de serrage (242) isolant de l'électricité pour recevoir une pièce et 2n électrodes conductrices (210-220), où n est un nombre entier égal ou supérieur à 3, en dessous de ladite surface de serrage et isolées électriquement de celle-ci, et
des moyens de commande de serrage (202) pour appliquer des tensions alternatives auxdites électrodes lorsque le serrage de la pièce est souhaité, la pièce étant serrée par voie électrostatique en position fixe sur ladite surface de serrage lorsque lesdites tensions alternatives sont appliquées auxdites électrodes, lesdits moyens de commande de serrage comprenant des moyens (260-264) pour générer 2n tensions à onde carrée bipolaires ayant des phases relatives de même décalage, lesdites tensions à onde carrée définissant n séries de tensions à onde carrée, chacune desdites séries comprenant des tensions à onde carrée bipolaires positives et négatives qui sont décalées en phase d'un demi-cycle, chacune desdites tensions à onde carrée bipolaires ayant une vitesse de commutation prédéterminée sélectionnée pour limiter des périodes transitoires qui pourraient potentiellement endommager une pièce, et des moyens (280-295) pour coupler lesdites séries de tension à onde carrée auxdites électrodes afin d'obtenir un serrage symétrique de la pièce sur ladite surface de serrage.

2. Appareil selon la revendication 1, dans lequel n est égal à 3.

3. Appareil selon la revendication 1 ou 2, dans lequel chacune desdites tensions à onde carrée a une fréquence fondamentale dans la plage de 1 à 300 Hz.

4. Appareil selon la revendication 3, dans lequel chacune desdites tensions à onde carrée a une fréquence fondamentale dans la plage de 20 à 50 Hz.

5. Appareil selon la revendication 4, dans lequel chacune desdites tensions à onde carrée a une fréquence fondamentale de 30 Hz.

6. Appareil selon l'une quelconque des revendications 1 à 5, dans lequel ladite vitesse de commutation est de 3 millisecondes.

7. Appareil selon l'une quelconque des revendications 1 à 6, dans lequel ladite surface de serrage comprend un matériau diélectrique (230 à 240) sélectionné dans le groupe constitué de l'alumine, du saphir et du nitrure d'aluminium.

8. Appareil selon la revendication 7, dans lequel ledit matériau diélectrique comprend de l'alumine.

9. Appareil selon la revendication 8, dans lequel lesdites électrodes comprennent une couche de molybdène et une mince couche de titane entre ladite couche de molybdène et ledit matériau diélectrique.

10. Appareil selon l'une quelconque des revendications 1 à 9, dans lequel ladite surface de serrage comprend un matériau diélectrique conducteur de la chaleur.

11. Appareil selon l'une quelconque des revendications 1 à 10, dans lequel ladite platine comprend par ailleurs un substrat isolant (206) pour supporter chacune desdites électrodes et ladite surface de serrage.

12. Appareil selon la revendication 11, dans lequel ladite platine comprend par ailleurs une plaque de support (204) pour ledit substrat isolant.

13. Appareil selon la revendication 12, dans lequel ladite plaque de support comprend un passage (208, 420) pour faire circuler un liquide de refroidissement.

14. Appareil selon l'une quelconque des revendications 1 à 13, dans lequel lesdites électrodes sont disposées symétriquement par rapport au centre de ladite surface de serrage, les tensions à onde carrée de chacune desdites séries étant couplées à des électrodes sur les côtés opposés de ladite surface de serrage.

15. Appareil selon l'une quelconque des revendications 1 à 14, dans lequel lesdites électrodes comprennent des couches métalliques sous-jacentes audit matériau diélectrique.

16. Appareil selon la revendication 15, dans lequel lesdites électrodes comprennent des couches métalliques formées sur ledit matériau diélectrique.

17. Appareil selon la revendication 15, dans lequel lesdites électrodes comprennent des couches métalliques évaporées sur ledit matériau diélectrique.

18. Appareil selon l'une quelconque des revendications 1 à 17, dans lequel lesdites électrodes ont des surfaces égales.

19. Appareil selon l'une quelconque des revendications 1 à 18, dans lequel ladite surface de serrage est plate.

20. Appareil selon l'une quelconque des revendications 1 à 19, dans lequel ladite platine comprend par ailleurs une bague de mise à la terre périphérique (302) pour venir en contact avec ladite pièce.

21. Appareil selon l'une quelconque des revendications 1 à 20, dans lequel ledit matériau diélectrique ne présente pas de polarisation globale à la fréquence et à la tension desdites tensions à onde carrée.

22. Appareil selon l'une quelconque des revendications 1 à 21, dans lequel lesdites tensions à onde carrée bipolaires ont une amplitude de pic dans la plage de 900 à 1200 volts.

23. Appareil selon l'une quelconque des revendications 1 à 22, dans lequel ledit matériau diélectrique comprend des isolants diélectriques, un pour chacune desdites électrodes.

24. Appareil selon les revendications 11, 16 et 26, dans lequel lesdits isolants diélectriques sont liés audit substrat isolant par des agents de fixation de tétrafluoréthylène.

25. Appareil selon l'une quelconque des revendications 1 à 24, comprenant par ailleurs des moyens (404) pour introduire un gaz dans une région comprise entre ladite pièce et ladite surface de serrage pour acheminer de l'énergie thermique entre ladite pièce et ladite surface de serrage.

26. Appareil selon la revendication 25, comprenant par ailleurs des moyens (410-416) pour sceller la région formée entre ladite pièce et de ladite surface de serrage au voisinage de sa périphérie extérieure pour empêcher l'échappement dudit gaz de ladite région.

27. Appareil selon l'une quelconque des revendications 1 à 26, comprenant par ailleurs des moyens (404) pour refroidir ladite platine.

28. Appareil selon l'une quelconque des revendications précédentes, dans lequel la surface de serrage est circulaire.

29. Appareil selon la revendication 28, dans lequel lesdites électrodes comprennent des électrodes en forme de secteurs ayant des surfaces égales.
